# EUROPEAN PATENT SPECIFICATION

(11) **EP 0 612 108 B1**
(45) Date of publication and mention of the grant of the patent: **04.07.2001**
(21) Application number: 93830062.1
(22) Date of filing: 19.02.1993
(51) Int. Cl.: H01L 27/115, H01L 29/788, G11C 16/04

(54) **Double polysilicon EEPROM cell and corresponding manufacturing process**
EEPROM-Zelle mit doppelter Polysiliziumschicht und ihr Herstellungsverfahren
Cellule EEPROM à double couche de polysilicium et son procédé de fabrication

(43) Date of publication of application: 24.08.1994
(73) Proprietor: STMicroelectronics S.r.l., 20041 Agrate Brianza (Milano) (IT)
(72) Inventor: Pio, Federico, I-2014 Milano (IT); Riva, Carlo, I-20055 Renate Brianza (MI) (IT)
(74) Representative: Botti, Mario

(56) References cited:
- EP-A- 0 079 636
- EP-A- 0 379 693
- US-A- 4 742 492
- US-A- 4 852 062
- US-A- 5 081 054

## Description

### Field of Application

This invention relates to an EEPROM memory cell having two levels of polysilicon.

In particular, the invention concerns a two-level polysilicon EEPROM memory cell of a type which comprises a floating gate transistor connected serially to a selection transistor and provided with a further control gate overlying the floating gate, an intermediate dielectric layer being interposed between the gates.

The invention further concerns a manufacturing process for such memory cells.

### Prior Art

As is well known, EEPROM memory structures, while being of the non-volatile type, allow the information stored therein to be altered electrically both during the write and the erase phases.

In essence, EEPROMs can have the state of any memory cells altered by tunnelling electrons through a thin layer of silicon oxide.

The thin oxide region has a smaller area than the so-called floating gate whereinto the electric charge is stored.

Memory cells with the above-outlined construction are referred to as FLOTOX, and are described, for example, in an article entitled "Oxide reliability criterion for the evaluation of endurance performance of electrically erasable programmable read-only memories", Journal App. Phys. 71, No. 9, 1992.

This kind of EEPROM memories falls into two general classes: a first class provided with a single level of polysilicon, and a second class having two distinct levels of polysilicon.

Memories of the first class have an advantage in that they can be manufactured by a comparatively simple process; but the overall circuit space requirements are much higher, usually by a factor of 1.5 to 2.5.

This penalizes memories with a single level of polysilicon in all those applications which require high circuit density, e.g. in excess of one Megabit.

It should be noted here that memories of either classes, whether with one or two levels of polysilicon, use positive voltages for both writing and erasing purposes. These voltages range from 8 to 12 Volts in order to generate a sufficiently strong electric field across the thin oxide to effectively trigger the tunnel effect.

However, the use of these relatively high positive voltages may eventually result in the thin oxide layer becoming deteriorated.

A first prior art solution to realize a two-level polysilicon EEPROM memory cell is disclosed in the U.S. patent No. US-A-5,081,054 which discloses a floating gate transistor connected serially to a selection transistor and provided with a further control gate overlying the floating gate. An intermediate dielectric layer is interposed between such gates.

A region comprising a double implant of the same dopant, at two different concentrations, is provided between the respective gate terminals of the selection transistor and the floating gate transistor.

However, in this solution the selection transistor has only one polysilicon layer and the double implant is located only between the floating gate and the selection transistor.

Other solutions are known from the European patent applications EP-A-0 379 693 and EP-A-0 079 636. The first of these documents describes a FLOTOX EEPROM cell in which no double implant is provided between the floating gate and the selection transistor, while in the second document no spacers are provided at the sides of the floating gate.

Other prior art documents are U.S. patent No. US-A-4, 852, 062 and US-A-4 742 492 which relate to EPROM cells without a selection transistor.

The underlying technical problem of this invention is to provide a two-level polysilicon EEPROM cell which has such structural and functional features as to allow very high density integrated storage circuits so that such circuits may be produced in much smaller circuit area, with a given technology. This drastically cuts down the manufacturing costs of high density storage circuits.

Another object of this invention is to enhance the reliability and lifelong of storage circuits implemented with such cells.

The solutive idea on which this invention is based consists in providing a novel cell configuration which allows the silicon voltages to be lowered by re-distribution of the voltages applied across the thin tunnel oxide layer.

Based on such solutive idea, the technical problem is solved by an EEPROM memory cell as indicated above and defined in the characterizing portion of Claim 1.

The technical problem is also solved by a memory cell manufacturing process as defined in claim 6.

The features and advantages of a memory cell according to the invention will become apparent from the following description of an embodiment thereof, given by way of example and not of limitation with reference to the accompanying drawings.

### Brief Description of the Drawings

In the drawings:
Figure 1 is a top plan view showing schematically the layout of a memory cell embodying this invention;
Figure 2 is an enlarged scale, schematic view showing, in a vertical section taken along line II-II in Figure 1, a semiconductor portion on which the cell of this invention has been formed;
Figure 3 is an enlarged scale, schematic view showing a vertical section through that same semiconductor portion but taken along line III-III in Figure 1;
Figures 4 to 6 are respective schematic views showing, in vertical section and time succession, the initial steps of the manufacturing process to yield a pair of the cells shown in Figure 1; and,
Figures 7 to 9 are respective schematic views showing, in vertical section and time succession, the final steps of the manufacturing process to yield a pair of the cells according to the invention.

### Detailed Description

With reference to the drawing views, generally and schematically shown at 1 is an EEPROM memory cell embodying this invention. Understandably, the cell 1 would be a basic component of an integrated storage circuit incorporating thousands of identical cells in a matrix.

The structure of this cell 1 will next be described with cross reference to the steps of its manufacturing process.

The cell 1 is of the two-level polysilicon type and has a basic structure which is consistent with a Flash cell of the ETOX type. In essence, the core of the memory cell comprises a MOS transistor having a floating gate 12 where the electric charge is stored which allows identification of the two discrete cell states of "write" and "erase".

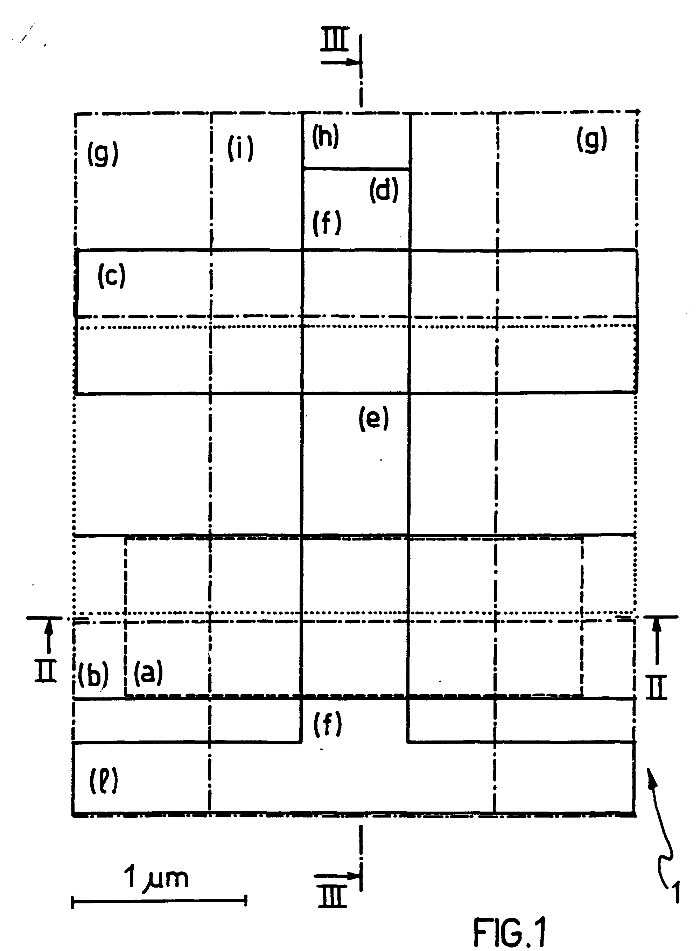

The floating gate 12 is represented in Figure 1 by a region (a) contoured by a dash line.

Provided above the floating gate 12 is a control gate electrode 15 comprising two overlapping layers of polysilicon 9 and silicide 13. In Figure 1, the control gate is represented by a region (b).

The control gate 15 is coupled capacitively to the floating gate 12 through an intervening dielectric layer 11, referred to as the interpoly layer. A voltage is transferred through this dielectric layer 11 to the floating gate 12 from the control gate 15 during the cell 1 write and/or erase phases.

Advantageously, the control gate electrode 15 is shared by all the cells forming one row or sector in the integrated storage circuit.

Connected serially to the cell 1 is a so-called selection transistor 14 which is designed to only operate at low voltages in the 5 to 7 Volts range. Region (c) in Figure 1 shows the location of this transistor 14.

The gate of this transistor 14 is also formed of a double layer of polysilicon 9 and silicide 13, and is shared by all the cells in one row of the integrated matrix.

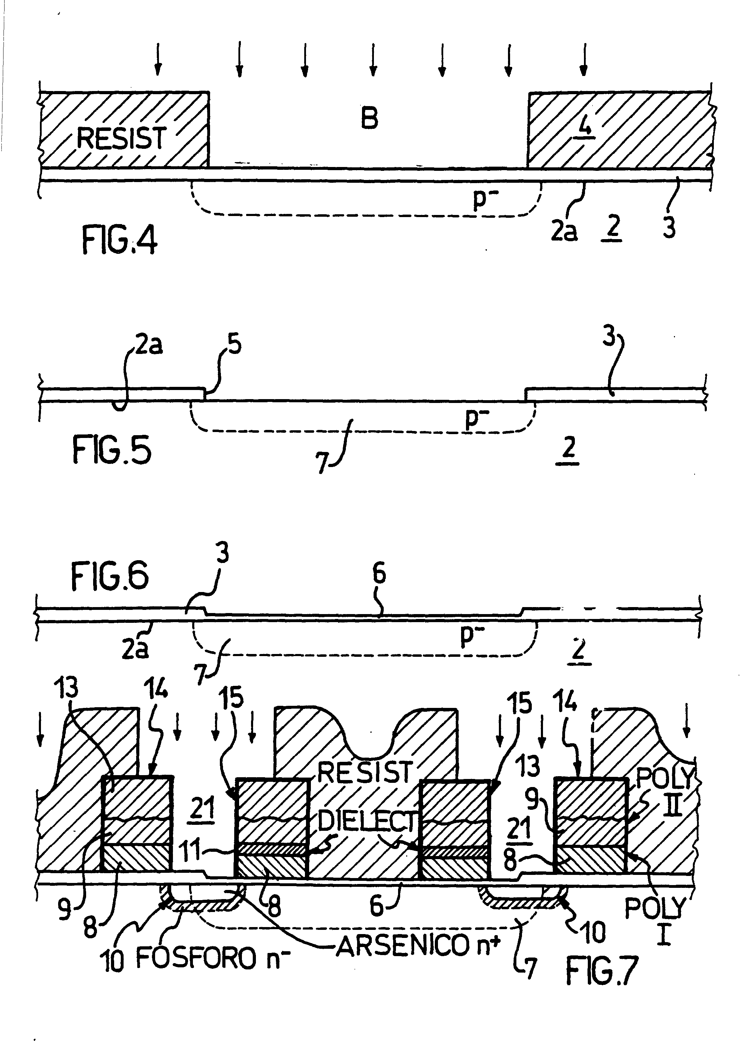

Associated with the transistor 14 are active areas 20, shown in Figure 3 and indicated in Figure 1 by a region (d).

Advantageously according to the invention, located between the respective gate terminals of the selection transistor 14 and the cell 1 is a region 10 which has at least dual implant of the same dopant at two different concentrations thereof.

In the instance considered, the dopant is of the N type and the implantation is effected using phosphorus and arsenic ions. Such a dual implant has shown to be specially effective to keep the so-called band-to-band (BTB) current low during the cell write phase.

In Figure 1, the region 10 is denoted by the character (e) and circumscribed by a dot line.

This region 10 is formed by carrying out a first phosphorus implantation at a low concentration of dopant N- and a subsequent, implantation of arsenic N+ at a greater concentration.

Advantageously, the transistor forming the cell 1 has respective drain 28 and source 29 active regions, each with the same construction as region 10.

The reference character (f) denotes in Figure 1 the drain and source regions of the cell 1. Indicated at (h) is, moreover, a drain contact between the cell 1 and an overlying cell, not shown because symmetrical with that described herein.

The reference character (i) denotes an interconnection metallic line between the drain contacts of cells in the same column of the cell matrix which makes up the integrated storage circuit.

Lastly, the reference character (l) denotes a line interconnecting the source regions which is shared by all the cells in the same row or row sector of the matrix. This interconnection line (l) is also common to the source regions in the underlying row of symmetrical cells within the integrated circuit matrix.

Steps of the process for manufacturing memory cells according to the invention will now be described in detail.

The cell 1 is formed on a semiconductor substrate 2 with a 0.8 µm technology and having a control gate-to-floating gate capacitive coupling of about 0.6-0.7.

A gate oxide layer 3 is grown on the surface 2a of the substrate 2 by thermal oxidation. This layer 3 is specifically intended for the selection transistor 14.

Using a conventional photolithographic technique whereby a layer 4 of a photoresist is deposited over the oxide 3, followed by wet etching, an aperture 5 is cut in the oxide layer 3 as shown in Figure 5. This aperture 5 will substantially expose again the surface 2a of the substrate 2.

Simultaneously therewith, an elongate channel region 7 which extends to beneath the opposite edges of the layer 3 is formed, proximate to the surface 2a, beneath the aperture 5 by ion implantation. The implantation is carried out using Boron ions to provide doping of the P- type in the region 7.

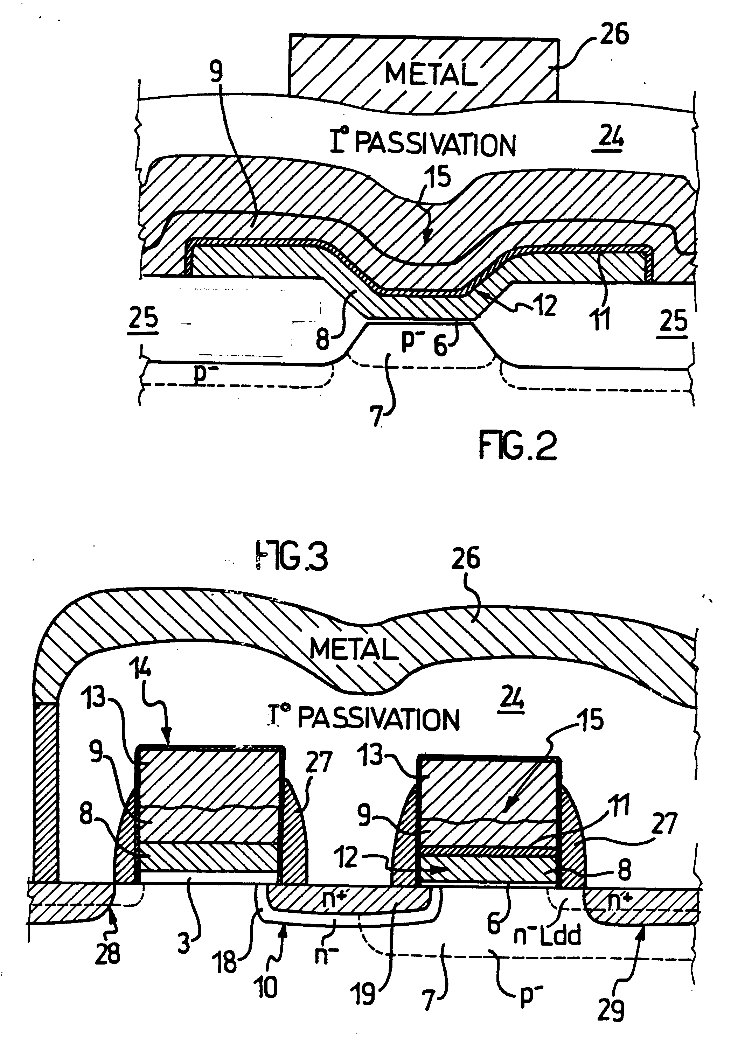

At this time, a thin oxide layer 6, referred to as the tunnel oxide hereinafter, is grown by thermal oxidation within the aperture 5. This tunnel oxide 6 is bounded laterally by opposite field oxide regions 25, as shown in Figure 2 and denoted in Figure 1 by the reference character (g).

The field oxide 25 delimits the active areas of the transistor with respect to the gate terminal.

Subsequent processing steps, known per se, will provide first 8 and second 9 polysilicon layers intended for the structures of the floating gate 12 and the associated control gate 15 of the cell 1, as well as of the gate of the selection transistor 14.

Provided over the floating gate 12 between the first 8 and second 9 polysilicon layers, is the interpoly dielectric layer 11.

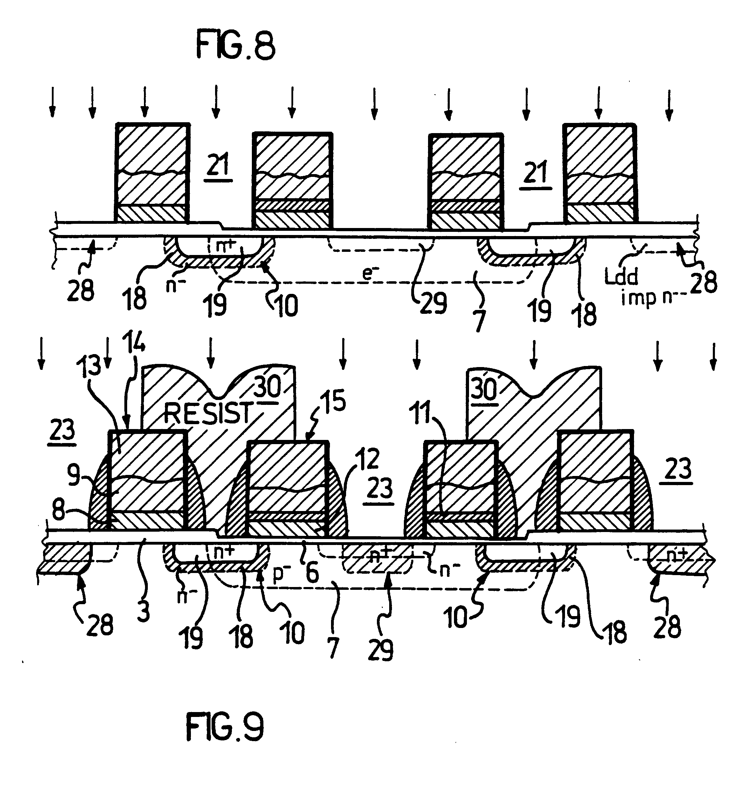

Using a photolithographic technique, respective apertures 21 are defined, throughout the layers 13, 9, 11 and 8, as far as the oxide layers 3 and 6. This process step is shown schematically in Figure 7 with reference to the implementation of a pair of the cells 1. These apertures 21 are cut between the respective gate terminals of each cell 1 and each corresponding selection transistor 14.

A subsequent step of double ion implantation yields regions 10 which have two different concentrations of the same dopant type.

More specifically, an implantation followed by diffusion of Phosphorus ions enables a first region 18 doped N- to be defined. This first region 18 will receive a second region 19 to be formed by implantation and successive diffusion with Arsenic ions. The first region 18 extends farther than said second region 19 below the floating gate 12 and below the gate of the selection transistor 14, as shown in Figures 3 and 7.

This second Arsenic implant is at a greater concentration than the previous Phosphorus implant, and the region 19 will have a concentration of dopant of the N+ type. The concentration gradient of the dopant N between the regions 18 and 19 lowers the so-called tunneling of the band-to-band current during the cell "write" phase. Similarly, shown schematically in Figure 8 are the implantation steps which also enable the active drain and source areas 28 and 29 to be doped. Advantageously, this process step is carried out using a technique known as LDD (Low Density Diffusion) at a low dopant concentration.

Both the drain area 28 and source area 29 of the transistor comprising the cell 1 are denoted by the reference character (f) in Figure 1 and circumscribed by respective dash-and-dot lines. At this stage, spacers 27 are formed, and by masking with a photoresist 30, also the apertures 21 for removing the silicide 13 and oxide 9 layers from above the source 29 and the drain regions 28 at the sides of the selection transistors 14.

This step allows new apertures 23 to be opened through which an implantation is carried out with arsenic N+ ions to complete the doping of the active areas 28 and 29, as shown in Figure 9.

The process steps are completed by the deposition of a passivating layer 24 and the provision of the final metallization layer 26. These, the very last, steps of the process are carried out in a conventional manner.

The method for programming the memory cell of this invention will now be described. In fact, the peculiarly innovative structure of this cell 1 allows it to be programmed in quite unique a manner.

For cell writing and erasing in conventional storage circuits, positive voltage pulses are applied to the cell terminals in order to generate a sufficient electric field to cause a current flow through the tunnel oxide layer.

By contrast, in the cell 1 of this invention, a negative voltage is used for application to the control gate 15 during the write phase.

When such negative voltage is used, the voltage being applied to the drain terminal can be reduced while retaining through the thin oxide 6 an electric field of the same level as in conventional cells.

This will reduce the maximum energy of the so-called holes generated by the band-to-band current at the junction of the drain region. Accordingly, the deterioration of the thin tunnel oxide can be greatly reduced.

The memory cell of this invention does solve the technical problem, and affords a number of advantages as specified herein below.

The peculiar structure of the cell 1 allows it to be compacted, for a given technology, within an area which is less than one half that occupied by a conventional two-level polysilicon cell.

The use of a negative voltage to the control gate 15 of the cell, during the write phase, makes it possible to control the maximum programming current. Accordingly, the cell performance and long-term reliability are improved, since the deterioration of the thin silicon oxide 6 subjected to the tunnel effect has been reduced.

In view of that the operation of the inventive cell is based on a Fowler-Nordheim tunnel effect and that its inherent threshold can be selected close to zero, the instant structure will specially suit low supply voltage applications, even ones as low as 3 Volts.

The overall electric length of the inventive cell is greater than that of a Flash cell, and in addition:
- the diffusion of Phosphorus through the drain region is much reduced because channel doping is slight, whereby the voltages applied to the drain can be small, on the order of 4-6 Volts;
- with the source being formed by the LDD method, the heavy Arsenic implant, peripherally of the source and the drain regions, can be held away from the cell gate.

The last-mentioned features of the invention foster very large scale integration of the inventive cell, increasing its effective electric length.

Understandably, changes and modifications may be made unto the memory cell as described and illustrated in the foregoing without departing from the invention scope as defined in the appended claims.

## Claims

1. A two-level polysilicon EEPROM memory cell comprising a semiconductor substrate (2), a floating gate transistor connected serially to a selection transistor (14) and provided with a further control gate (15) overlying the floating gate (12), an intermediate dielectric layer (11) being interposed between said gates, the floating gate transistor having a first active region (29) forming the source region (29) of the memory cell, the selection transistor having a first active region (28) forming the drain region (29) of the memory cell, the floating gate transistor and the selection transistor having a common second active region (10) comprising a first implanted region (18) and a second implanted region (19), said implanted regions (18,19) having different concentrations of the same dopant conductivity type, characterized in that said second implanted region (19) is formed within said first implanted region (18) and in that said first implanted region (18) extends farther than said second implanted region (19) both below the floating gate (12) and below the gate of the selection transistor (14), and in that the source region (29) also comprises a first source region (n-LDD) and a second source region (n+) having different concentrations of the same dopant conductivity type.

2. A memory cell according to Claim 1, characterized in that said second source region (n+) extends below a spacer (27) formed at one side of the floating gate transistor.

3. A memory cell according to claim 1, characterized in that said first and second active regions (28, 29, 10) are N type.

4. A memory cell according to Claim 1, characterized in that said first and second active regions (28, 29, 10) are formed by an implantation of Phosphorus and Arsenic ions.

5. An integrated EEPROM storage circuit in MOS technology, characterized in that it comprises a matrix of cells structured as claimed in Claim 1.

6. A manufacturing process for a dual-level polysilicon EEPROM memory cell of the type implemented in MOS technology on a semiconductor substrate (2) including at least one memory cell (1) comprising a floating gate transistor and a selection transistor (14) connected serially by a common active region (10) in said substracte (2) to the floating gate transistor, the process comprising the following steps:
forming a first implanted region (18) extending below both the selection transistor gate and the floating gate (12);
forming a second implanted region (19), within said first implanted region (18) extending below both selection transistor gate and the floating gate (12), the first implanted region (18) extending farther than said second implanted region (19), said first and second implanted regions forming said common active region (10) in said substrate (2); and
forming a third region (n-LDD) and a forth region (n+) having different concentrations of the same dopant conductivity type on the opposite side to the first implanted region (18) in respect to the floating gate (12) to realize the source region (28) of the memory cell.

7. A process according to claim 6, characterized by further comprising:
forming spacers (27) at both sides of the floating gate (12) transistor, and
forming said fourth region (n-LDD) extending below one of said spacers (27).

8. A process according to Claim 6, characterized in that said first implanted region (18) and third region (n- LDD) are formed by a first implantation of N- ions; said second implanted region (19) and said fourth region (n+) being formed by a second implantation of N+ ions.

9. A process according to Claim 8, characterized in that said first implantation is formed by Phosphorus at a low concentration of dopant and said second implantation by Arsenic at a greater concentration.

## Patentansprüche

1. EEPROM-Speicherzelle mit doppelter Polysiliziumschicht, umfassend ein Halbleitersubstrat (2), einen Floating-Gate-Transistor, der in Reihe zu einem Auswahltransistor (14) geschaltet und mit einem weiteren, über dem Floating-Gate (12) liegenden Steuergate (15) ausgestattet ist, eine dielektrische Zwischenschicht (11) zwischen den Gates, wobei der Floating-Gate-Transistor eine erste aktive Zone (29) aufweist, welche die Source-Zone (29) der Speicherzelle bildet, der Auswahltransistor eine erste aktive Zone (28) besitzt, die die Drain-Zone (29) der Speicherzelle bildet, wobei der Floating-Gate-Transistor und der Auswahltransistor eine gemeinsame zweite aktive Zone (10) mit einer ersten implantierten Zone (18) und einer zweiten implantierten Zone (19) besitzen, welche implantierten Zonen (18, 19) unterschiedliche Konzentrationen an Dotierstoff gleichen Leitungstyps besitzen, dadurch gekennzeichnet, daß die zweite implantierte Zone (19) innerhalb der ersten implantierten Zone (18) gebildet ist, und daß die erste implantierte Zone (18) sich sowohl unterhalb des Floating-Gates (12) als auch unterhalb des Gates des Auswahltransistors (14) weiter erstreckt als die zweite implantierte Zone (19), und daß die Source-Zone (29) außerdem eine erste Source-Zone (n-LDD) und eine zweite Source-Zone (n+) mit unterschiedlichen Konzentrationen von Dotierstoff gleichen Leitungstyps besitzt.

2. Speicherzelle nach Anspruch 1, dadurch gekennzeichnet, daß die zweite Source-Zone (n+) sich unter einen Distanzbereich (27) erstreckt, der auf einer Seite des Floating-Gate-Transistors ausgebildet ist.

3. Speicherzelle nach Anspruch 1, dadurch gekennzeichnet, daß die erste und die zweite aktive Zone (28, 29, 10) N-leitend sind.

4. Speicherzelle nach Anspruch 1, dadurch gekennzeichnet, daß die erste und die zweite aktive Zone (28, 29, 10) durch Implantieren von Phosphor- und Arsen-Ionen gebildet sind.

5. Integrierte EEPROM-Speicherschaltung in MOS-Technologie, dadurch gekennzeichnet, daß sie eine Matrix aus Zellen aufweist, die gemäß Anspruch 1 strukturiert sind.

6. Verfahren zum Herstellen einer EEPROM-Speicherzelle mit doppelter Polysiliziumschicht, implementiert in MOS-Technologie auf einem Halbleitersubstrat (2) mit mindestens einer Speicherzelle (1), die einen Floating-Gate-Transistor und einen mit diesem durch eine gemeinsame aktive Zone (10) in dem Substrat (2) in Reihe geschalteten Auswahltransistors (14) aufweist, wobei das Verfahren folgende Schritte umfaßt:
Bilden einer ersten implantierten Zone (18), die sich unter sowohl das Auswahltransistor-Gate als auch das Floating-Gate (12) erstreckt;
Bilden einer zweiten implantierten Zone (19) innerhalb der ersten implantierten Zone (18), die sich unter das Auswahltransistor-Gate und das Floating-Gate (12) erstreckt, wobei die erste implantierte Zone (18) sich weiter als die zweite implantierte Zone (19) erstreckt und die erste und die zweite implantierte Zone die gemeinsame aktive Zone (10) in dem Substrat (2) bilden, und
Bilden einer dritten Zone (n-LDD) und einer vierten Zone (n+) mit unterschiedlichen Konzentrationen von Dotierstoff gleichen Leitungstyps auf der der ersten implantierten Zone (18) gegenüberliegenden Seite bezüglich des Floating-Gate (12), um die Source-Zone (28) der Speicherzelle zu bilden.

7. Verfahren nach Anspruch 6, gekennzeichnt durch:
Bilden von Distanzbereichen (27) auf beiden Seiten des Transistors mit Floating-Gate (12), und
Bilden der vierten Zone (n-LDD), die sich unter einem der Distanzbereiche (27) erstreckt.

8. Verfahren nach Anspruch 6, dadurch gekennzeichnet, daß die erste implantierte Zone (18) und die dritte Zone (n-LDD) durch ein erstes Implantieren von N- Ionen gebildet werden, und die zweite implantierte Zone (19) und die vierte Zone (n+) durch ein zweites Implantieren von N+-Ionen gebildet werden.

9. Verfahren nach Anspruch 8, dadurch gekennzeichnet, daß das erste Implantieren mit Phosphor geringer Dotierstoffkonzentration, und das zweite Implantieren mit Arsen höherer Konzentration erfolgt.

## Revendications

1. Cellule de mémoire EEPROM à double couche de polysilicium, comprenant un substrat semi-conducteur (2), un transistor à grille flottante connecté en série à un transistor de sélection (14) et muni d'une autre grille de commande (15) recouvrant la grille flottante (12), une couche diélectrique intermédiaire (11) interposée entre lesdites grilles, le transistor à grille flottante présentant une première zone active (29) formant la zone de source (29) de la cellule de mémoire, le transistor de sélection présentant une première zone active (28) formant la zone de drain (29) de la cellule de mémoire, le transistor à grille flottante et le transistor de sélection présentant une deuxième zone active (10) commune comprenant une première zone implantée (18) et une deuxième zone implantée (19), lesdites zones implantées (18, 19) présentant différentes concentrations du même type de conductivité de dopant, caractérisée en ce que ladite deuxième zone implantée (19) est formée à l'intérieur de ladite première zone implantée (18), et en ce que ladite première zone implantée (18) s'étend au delà de ladite deuxième zone implantée (19), les deux étant situées en dessous de la grille flottante (12) et en dessous de la grille du transistor de sélection (14), et en ce que la zone de source (29) comprend en outre une première zone de source (n-LDD) et une deuxième zone de source (n+) présentant différentes concentrations du même type de conductivité de dopant.

2. Cellule de mémoire selon la revendication 1, caractérisée en ce que ladite deuxième zone de source (n+) s'étend en dessous d'une entretoise (27) formée sur un côté du transistor à grille flottante.

3. Cellule de mémoire selon la revendication 1, caractérisée en ce que lesdites première et deuxième zones actives (28, 29, 10) sont du type N.

4. Cellule de mémoire selon la revendication 1, caractérisée en ce que lesdites première et deuxième zones actives (28, 29, 10) sont formées par une implantation d'ions phosphore et arsenic.

5. Circuit de mémoire EEPROM intégré dans une technologie MOS, caractérisé en ce qu'il comprend une matrice de cellules structurée tel qu'indiqué dans la revendication 1.

6. Procédé de fabrication d'une cellule de mémoire EEPROM à double couche de polysilicium du type mis en oeuvre dans la technologie MOS sur un substrat à semi-conducteur (2) comportant au moins une cellule de mémoire (1) comprenant un transistor à grille flottante, un transistor de sélection (14) connecté en série par une zone active (10) commune dans ledit substrat (2) au transistor à grille flottante, le procédé comprenant les étapes consistant à :
former une première zone implantée (18) s'étendant au-dessous de la grille du transistor de sélection et de la grille flottante (12) ;
former une deuxième zone implantée (19) à l'intérieur de ladite première zone implantée (18) s'étendant au-dessous de la grille du transistor de sélection et de la grille flottante (12), la première zone implantée (18) s'étendant au delà de ladite deuxième zone implantée (19), lesdites première et deuxième zones implantées formant ladite zone active (10) commune dans ledit substrat (2) ; et
former une troisième zone (n-LDD) et une quatrième zone (n+) présentant différentes concentrations du même type de conductivité de dopant sur le côté opposé à la première zone implantée (18) par rapport à la grille flottante (12) pour réaliser la zone de source (28) de la cellule de mémoire.

7. Procédé selon la revendication 6, caractérisé en ce qu'il comprend en outre les étapes consistant à :
former des entretoises (27) sur les deux côtés du transistor à grille flottante (12), et
former ladite quatrième zone (n-LDD) s'étendant au dessous de l'une desdites entretoises (27).

8. Procédé selon la revendication 6, caractérisé en ce que ladite première zone implantée (18) et ladite troisième zone (n-LDD) sont formées par une première implantation d'ions N- ; ladite deuxième zone implantée (19) et ladite quatrième zone (n+) étant formées par une deuxième implantation d'ions N+.

9. Procédé selon la revendication 8, caractérisé en ce que ladite première implantation est formée par du phosphore à basse concentration de dopant et ladite deuxième implantation par de l'arsenic à concentration plus élevée.
